# EUROPÄISCHE PATENTSCHRIFT

(11) **EP 2 191 502 B1**
(45) Veröffentlichungstag und Bekanntmachung des Hinweises auf die Patenterteilung: **16.01.2019**
(21) Anmeldenummer: 08802300.7
(22) Anmeldetag: 17.09.2008
(51) Int. Cl.: H01L 21/768, H01L 23/48

(54) **ELEKTRONISCHES SYSTEM UND VERFAHREN ZUR HERSTELLUNG EINES DREIDIMENSIONALEN ELEKTRONISCHEN SYSTEMS**
ELECTRONIC SYSTEM, AND METHOD FOR MANUFACTURING A THREE-DIMENSIONAL ELECTRONIC SYSTEM
SYSTÈME ÉLECTRONIQUE ET PROCÉDÉ POUR FABRIQUER UN SYSTÈME ÉLECTRONIQUE TRIDIMENSIONNEL

(30) Priorität: 19.09.2007 DE 102007044685
(43) Veröffentlichungstag der Anmeldung: 02.06.2010
(73) Patentinhaber: Fraunhofer-Gesellschaft zur Förderung der angewandten Forschung e.V., 80686 München (DE)
(72) Erfinder: RAMM, Peter, 85276 Pfaffenhofen (DE); KLUMPP, Armin, 80337 München (DE)
(74) Vertreter: Schenk, Markus
(86) Internationale Anmeldenummer: PCT/EP2008/007776
(87) Internationale Veröffentlichungsnummer: WO 2009/036969

(56) Entgegenhaltungen:
- WO-A-2008/083284
- US-A- 3 787 252
- US-A- 5 949 104
- US-A1- 2003 092 256

## Beschreibung

Die vorliegende Erfindung bezieht sich auf ein elektronisches System und auf ein Verfahren zur Herstellung von dreidimensionalen elektronischen Systemen und insbesondere auf ein Verfahren zur dreidimensionalen Integration elektronischer Systeme unter Verwendung von vorprozessierten Ausgangssubstraten.

Unter einer dreidimensionalen Integration wird im Allgemeinen eine vertikale Anordnung von Bauelementen verstanden, wobei sich die vertikale Verbindung auf eine Richtung zu einer Oberfläche oder Hauptseite eines Substrats oder einer Waferoberfläche bezieht. Die Verbindung kann dabei sowohl eine mechanische als auch eine elektrische Verbindung umfassen.

Im Zuge einer fortlaufenden Miniaturisierung und einer kompakten Ausgestaltung von integrierten Schaltungen ist es zunehmend wichtig, einen verfügbaren Raum möglichst optimal mit Bauelementen oder Schaltungen auszunutzen. Dies führt gleichzeitig zu einer Steigerung der Leistungsfähigkeit solcher optimal gestalteten Systeme, insbesondere dann, wenn höchst integrierbare vertikale Kontakte durch das Substrat frei wählbar sind. Bei einer Verwendung von Silizium als ein Beispiel, sind dies die so genannten "Through-Silicon Vias" (TSV).

Konventionelle Verfahren der dreidimensionalen Integration mit frei wählbaren vertikalen Kontakten basieren auf zwei Möglichkeiten:
a) Ausbildung von vertikalen Kontakten (Through-Silicon Vias) nach einer vollständigen Prozessierung der Bauelemente oder der Bauelementesubstrate; und
b) Herstellen der vertikalen Kontakte als Teile der Bauelementeherstellung und zwar nach Abschluss der so genannten Front-End-Of-Line- (FEOL-) Prozesse, jedoch noch vor den so genannten Back-End-Of-Line- (BEOL-) Prozessen.

Unter FEOL-Prozessen werden im Allgemeinen jene Prozess zusammengefasst, die das Prozessieren der Bauelement im Substrat umfassen - nicht jedoch das Ausbilden von Metallisierungs- und Oxidschichten, die beispielsweise der Kontaktierung und Verbindung der Bauelemente dienen und Teil der BEOL-Prozesse sind.

Beispiele für den Fall a) sind in EP 070362 (Verfahren zur Herstellung einer vertikalen integrierten Schaltungsstruktur) und in EP 1171912 (Verfahren zur vertikalen Integration von elektronischen Bauelementen mittels Rückseitenkontaktierung) beschrieben. Wie gesagt werden in beiden Fällen die vertikalen Kontakte nach der so genannten FEOL-Prozessierung vorgenommen. Der Fall b) ist beispielsweise in Mater. Res. Soc. Symp. Proc. Bd. 970, S. 8 beschrieben. Das Ausbilden der vertikalen Kontakte umfasst dabei beispielsweise einen Ätzprozess und ein Metallisieren (oder allgemein ein Auffüllen mit leitfähigen Material), um es elektrisch leitfähig zu machen.

Ein Vorteil eines Verfahrens gemäß Fall a) gegenüber einem Verfahren nach Fall b) besteht beispielsweise darin, dass in die Technologie der Bauelementeherstellung nicht eingegriffen wird. Bei dem Fall b) handelt es sich andererseits um ein Verfahren zur dreidimensionalen Integration, bei dem die Herstellung der vertikalen Kontakte ein Teil der Bauelementeherstellung ist, weil die vertikalen Kontakte nach Abschluss der so genannten FEOL-Prozesse, jedoch vor den BEOL-Prozessen stattfindet. Deshalb sind Verfahren gemäß b) dahingehend nachteilig, dass eine volle Kompatibilität der Ausbildung der vertikalen Kontakte mit den BEOL-Prozessen gebraucht wird. Andererseits sind diese Verfahren jedoch dahingehend vorteilhaft, dass die vertikale Durchkontaktierung nicht durch relativ dicke dielektrische Schichten, die verschiede Metallschichten der Mehrlagenmetallisierung trennen, realisiert zu werden braucht. Zusätzlich zu dem Substrat (beispielsweise ein Siliziumsubstrat) ist lediglich eine relativ dünne Dielektrikumsschicht unter der ersten Metallisierungslage von dem Ausbilden (z.B. durch Ätzen) der vertikalen Kontakte betroffen.

Ausgehend von diesem Stand der Technik liegt der vorliegenden Erfindung die Aufgabe zugrunde, ein elektronisches System und ein Verfahren für ein dreidimensional integriertes elektronisches System zu schaffen, bei dem das Ausbilden der vertikalen Kontakte ein Teil der Bauelementeprozessierung ist und somit eine weitere Steigerung einer Packungsdichte und Schaltgeschwindigkeiten möglich wird.

Diese Aufgabe wird durch ein Verfahren gemäß Anspruch 1, eine integrierte elektronische Schaltungsanordnung gemäß Anspruch 11 gelöst.

Der vorliegenden Erfindung liegt die Erkenntnis zugrunde, dass ein Verfahren zur Herstellung eines dreidimensionalen elektronischen Systems oder eine dreidimensionale Integration dadurch möglich wird, dass zunächst eine erste integrierte Schaltungsstruktur in einem ersten Substrat bereitgestellt wird, wobei die erste integrierte Schaltungsstruktur eine Kontaktfläche an einer Hauptseite oder Oberfläche des ersten Substrats aufweist. Ferner wird an einer Hauptseite eines zweiten Substrats ein vertikaler Kontaktbereich ausgebildet, wobei der vertikale Kontaktbereich sich senkrecht zu der Hauptseite des zweiten Substrats erstreckt. In einem Folgeschritt wird eine Halbleiterschicht (oder epitaktische Schicht) auf der Hauptseite des zweiten Substrats ausgebildet. In dem daraus resultierenden zweiten Substrat mit der epitaktischen Schicht wird mindestens ein Halbleiterbauelement einer zweiten integrierten Schaltungsstruktur ausgebildet. Daran anschließend wird Substratmaterial von einer der Hauptseite des zweiten Substrats gegenüberliegender Seite entfernt und zwar derart, dass der vertikale Kontaktbereich an der gegenüberliegenden Seite freigelegt wird. Schließlich wird das erste und zweite Substrat aufeinander angeordnet, so dass der vertikale Kontaktbereich die Kontaktfläche kontaktiert und eine elektrische Verbindung zwischen der ersten und der zweiten integrierten Schaltungsstruktur über den vertikalen Kontaktbereich und der Kontaktfläche hergestellt werden kann und somit eine dreidimensionale integrierte Schaltung erzeugt wird. Die Ausbildung der epitaktischen Schicht kann beispielsweise durch einen entsprechenden Wachstumsprozess, bei dem Substratmaterial unter Einhaltung der Gitterstruktur aufwächst, geschehen.

Ausführungsbeispiele der vorliegenden Erfindung beschreiben somit ein Verfahren zur Herstellung von dreidimensionalen elektronischen Systemen, bei denen zunächst das erste Substrat und das zweite Substrat bereitgestellt werden, wobei im ersten Substrat bereits ein oder mehrere Bauelemente prozessiert worden sind. Im zweiten Substrat sind zunächst jedoch keine Bauelemente realisiert und stattdessen werden zunächst die später zu realisierenden vertikalen elektrischen Durchkontaktierungen (vertikale Kontakte oder Kontaktbereiche) in einem ersten Schritt vorbereitet. Dies kann derart geschehen, dass zunächst eine Ausnehmung wie ein Graben, Locher oder ein Grabenstruktur im zweiten Substrat geschaffen werden. Die Seitenflächen der Ausnehmung kann gegebenenfalls durch ein Aufbringen oder Einbringen von dielektrischem Material von dem Substrat isoliert werden. Daran anschließend wird wie gesagt das zweite Substrat an der Oberfläche (Hauptseite) mit einer epitaktischen Schicht versehen, die für die Herstellung des Bauelements als Substratschicht dient (bzw. dafür geeignet ist). Das Ausbilden der epitaktischen Schicht kann dabei derart geschehen, dass die Ausnehmung geschlossen, nicht jedoch gefüllt wird. Die Epitaxieschicht bedeckt beispielsweise die Ausnehmung. Um dies zu erreichen, kann die Öffnungsbreite der Ausnehmung kleiner gewählt sein als eine mittlere freie Weglänge der Substratatome, die sich beim epitaktischen Abscheiden auf dem zweiten Substrat entsprechenden der Gitterstruktur anordnen. Wenn die mittlere freie Weglänge der sich abscheidenden Substratatome größer ist als eine seitliche Ausdehnung (laterale Ausdehnung) der Ausnehmung, dann werden die sich abscheidenden Atome keinen Weg finden, sich tiefer in die Ausnehmung in dem zweiten Substrat abzuscheiden und ein Verschluss erfolgt lediglich am oberen Teil.

Bei weiteren Ausführungsbeispielen werden in einer Prozessfolge im zweiten Substrat die zu integrierenden Bauelementen prozessiert. Die Bauelemente werden über Verbindungsstrukturen und Durchkontaktierungen (z.B. vertikale Kontaktbereiche) elektrisch miteinander verbunden. Die Verbindungsstrukturen können beispielsweise als metallische oder leitfähig dotierte (Halbleiter) Kontaktflächen ausgebildet sein und im Zug der Bauelementeherstellung an den späteren Positionen der vertikalen Kontakte realisiert werden - sie werden somit in vertikaler Richtung oberhalb der Ausnehmung im zweiten Substrat ausgebildet. Nach einer vollständigen Prozessierung der Bauelemente wird das zweite Substrat von der Rückseite (= der der Hauptseite gegenüberliegenden Seite) gedünnt bzw. Substratmaterial abgetragen, so dass die Ausnehmung an der Rückseite oder Unterseite geöffnet wird.

Die Ausnehmung kann anschließend von der Rückseite her beispielsweise durch ein Ätzen der Substratschicht (z. B. Epitaxieschicht) und gegebenenfalls einer dielektrischen Schicht bis zu der oben beschriebenen Kontaktfläche verlängert werden. Wenn das geschehen ist, kann die Ausnehmung mit leitfähigem Material (z.B. Kupfer) aufgefüllt werden, so dass eine Kontaktierung der Kontaktflächen oder Verbindungsstrukturen erfolgt. An der rückseitigen Oberfläche kann die mit leitfähigem Material aufgefüllte Ausnehmung mit einer strukturierten Metallkontaktfläche versehen werden. Die strukturierte Metallkontaktfläche kann beispielsweise Kupfer oder Zinn oder auch andere leitfähige Materialien aufweisen. Alternativ können auch andere nichtmetallische Materialien zur Anwendung kommen.

Das erste Substrat kann beispielsweise bei Ausführungsbeispielen ebenfalls mit einer strukturierten Metallfläche oder einer anderen Kontaktfläche versehen werden, die beispielsweise ebenfalls Kupfer oder Zinn aufweisen kann. Die strukturierte Metallfläche an dem ersten Substrat kann wiederum über Durchkontakte (Vias) mit einer der Verdrahtungsebenen eines Bauelementes im ersten Substrat elektrisch verbunden sein. Die Verdrahtungsebenen können beispielsweise als Metallisierungsebenen in einer MOS-Struktur ausgebildet sein, wobei innerhalb des Halbleitersubstrats dotierte Gebiete ausgebildet sind, die wiederum mit Durchkontaktierungen und über Verdrahtungsebenen miteinander verbunden sind.

In einem Folgeschritt kann das zweite Substrat nun mit dem ersten Substrat Rückseite zu Vorderseite, d. h. die beiden ausgebildeten Kontaktflächen zueinander, mechanisch und elektrisch leitfähig über die beschriebenen strukturierten Metallflächen verbunden werden.

Das bei Ausführungsbeispielen der vorliegenden Erfindung eingesetzte Verfahren der Kontaktierung der beiden strukturierten Metallflächen kann ohne Einschränkung der Allgemeinheit beispielsweise gemäß einem herkömmliche Weichlötverfahren oder gemäß einem Niedertemperaturlötverfahren durchgeführt werden. Weichlötverfahren beruhen oft auf einer "Solid-Liquid-Interdiffusion" zweier Metalle und ermöglichen eine stabile Verbindung bis weit oberhalb der Bond-Temperatur. Entsprechend bildet sich beim Bonden (Verbinden der beiden strukturierten Metallflächen) eine eutektische Legierung, deren Schmelzpunkt nach dem Zusammenfügen höher als die Schmelzpunkte der einzelnen Komponenten vor dem Zusammenfügen ist. Es bildet sich daher eine insofern irreversible Verbindung, als dass sie stabil ist gegenüber denjenigen Bedingungen, unter denen sie entstanden ist. Beispiele für Metallkombinationen, die gemäß Ausführungsbeispielen der vorliegenden Erfindung für die elektrische und mechanische Verbindung verwendet werden können, sind Kupfer und Zinn oder Gold und Titan jeweils für Vorder- und Rückseitenkontakte bzw. für Kontakte an dem ersten und zweiten Substrat. Somit sind die Bauelemente des ersten und zweiten Substrats über die vertikalen elektrisch leitfähigen Gräbenstrukturen zwischen den Bauelementeverdrahtungen dreidimensional integriert und miteinander verbunden.

Das soeben beschriebene Verfahren stellt ein Ausführungsbeispiel (Variante 1) der vorliegenden Erfindung dar. In einer Variante 2 des oben beschriebenen Verfahrens kann die Metallisierung der Ausnehmung statt von der Rückseite nach dem Dünnen des zweiten Substrats auch vor dem Dünnen von der Vorderseite her erfolgen. Hierzu wird vor dem Herstellen der metallischen oder dotiert leitfähigen Kontaktflächen die Substratschicht (z.B. die epitaktische Schicht) über der Ausnehmung geöffnet und die Ausnehmung kann anschließend mit leitfähigem Material (z.B. Kupfer) versehen werden. Nach der anschließenden vollständigen Prozessierung der Bauelemente wird wiederum das zweite Substrat von der Rückseite gedünnt, bis die nun bereits metallisierte Ausnehmung geöffnet ist und an der rückseitigen Oberfläche wie oben beschrieben mit einer strukturierten Kontaktfläche versehen werden können. Die strukturierte Kontaktfläche kann beispielsweise wiederum Kupfer oder Zinn aufweisen.

Bei einem weiteren Ausführungsbeispiel (Variante 3) des oben beschriebenen Verfahrens erfolgt die Metallisierung der Ausnehmung bereits vor der Abscheidung der beispielhaften epitaktischen Schicht, die für die Herstellung des Bauelements als Substratschicht geeignet ist. Das Bauelement kann bei einem weiteren Ausführungsbeispiel natürlich auch in dem zweiten Substrat ausgebildet werden oder sich über die epitaktische Schicht bis in das zweite Substrat hinein erstrecken. Wenn die Ausnehmung jedoch bereits vor der Abscheidung der beispielhaften epitaktischen Schicht mit leitfähigem Material gefüllt wurde, ist darauf zu achten, dass die Metallisierung kompatibel zur Gesamtprozessierung (FEOL- und BEOL-Fertigung) der Bauelemente ist. In einem solchen Fall kann als mögliche Metallisierung beispielsweise auch Wolfram eingesetzt werden.

Bei weiteren Ausführungsbeispielen können die beschriebenen Varianten der Herstellung von vertikalen elektrischen Verbindungen auch vorteilhafterweise ohne eine Justierung der metallischen oder dotiert leitfähigen Kontaktflächen erfolgen. Hierzu kann das zweite Substrat mit einer regelmäßigen Gräbenanordnung möglichst dicht versehen werden. Die regelmäßige Gräbenanordnung kann beispielsweise in Form eines translationssymmetrischen Rasters oder translationssymmetrischen Gitters ausgebildet sein und beispielsweise ein orthogonales oder hexagonales Raster umfassen. Die Kontaktflächen, die bei der Herstellung der Bauelemente ausgebildet werden, sollten im Verhältnis zum Gräbenraster geeignet groß gewählt werden, um eine weitgehende Freiheit hinsichtlich einer Positionierung der ausgewählten vertikalen Durchkontaktierungen zu erzielen. Anders herum könnte die Raster-Anordnung auch entsprechend eng gewählt sein, so dass eine vertikale Durchkontaktierung zu dem Raster, ohne dass es einer Justage bedarf. Für Kontaktflächen einer bestimmten Größer wäre die Kontaktierung immer gegeben. Durch eine derartige Vorgehensweise wird es möglich, quasi universell einsetzbare vorprozessierte Ausgangssubstrate für die Herstellung von dreidimensionalen integrierten elektronischen Systemen bereitzustellen. Ausführungsbeispiele der vorliegenden Erfindung sind somit hinsichtlich einer dreidimensionalen Integration elektronischer Systeme dahingehend vorteilhaft, dass damit unter Anderem eine deutlich höhere Packungsdichte und höhere Schaltgeschwindigkeit erreichbar wird. Die kürzeren Leitungswege stellen gegenüber herkömmlichen zweidimensionalen Systemen (Planartechnik) einen deutlichen Performancegewinn dar. Gegenüber der Planartechnik überwiegen die erreichbaren Vorteile, trotzdem mitunter erhöhte Fertigungskosten, insbesondere bei unvorteilhafter Prozessführung der dreidimensionalen Integration, vorkommen können.

Ausführungsbeispiele der vorliegenden Erfindung werden nachfolgend Bezug nehmend auf die beiliegenden Zeichnungen näher erläutert. Es zeigen:
- Fig. 1A,1B: Querschnittsansichten durch ein erstes Substrat mit fertig prozessierten Bauelementen mit und ohne einer Durchkontaktierung;
- Fig. 2A-2E: ein erstes Ausführungsbeispiel für eine Prozessführung für das Ausbilden einer integrierten Schaltungsstruktur mit einem vertikalen Kontaktbereich in dem zweiten Substrat;
- Fig. 3: eine Darstellung für ein vertikales Anordnen des ersten und zweiten Substrats bei gemäß einem Ausführungsbeispiel;
- Fig. 4A-4D: ein zweites Ausführungsbeispiel für eine Prozessführung zum Ausbilden der integrierten Schaltungsstruktur mit einem vertikalen Kontaktbereich in dem zweiten Substrat;
- Fig. 5A-5E: ein drittes Ausführungsbeispiel für eine Prozessführung zum Ausbilden einer integrierten Schaltungsstruktur mit vertikalen Kontaktbereichen; und
- Fig. 6: eine Draufsicht auf das zweite Substrat, bei dem der vertikale Kontaktbereich eine Rasterstruktur aufweist; und
- Fig. 7A-7E: ein viertes Ausführungsbeispiel für eine Prozessführung zum Ausbilden einer integrierten Schaltungsstruktur mit vertikalen Kontaktbereichen.

Bezüglich der nachfolgenden Beschreibung sollte beachtet werden, dass bei den unterschiedlichen Ausführungsbeispielen gleiche oder gleichwirkende Funktionselemente mit gleichen Bezugszeichen versehen sind und eine Beschreibung dieser Funktionselemente in den verschiedenen Ausführungsbeispielen untereinander austauschbar sind.

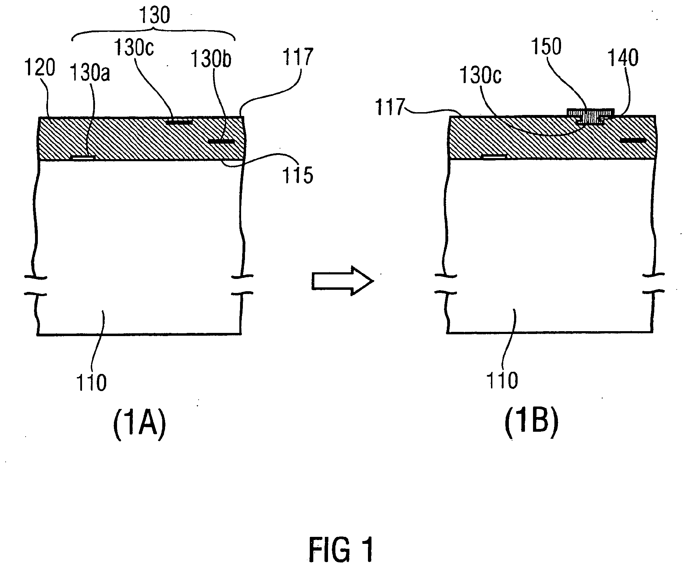

Die Fig. 1A und 1B zeigen Querschnittsansichten eines ersten Substrats 110 mit einer ersten integrierten Schaltungsstruktur. Konkret zeigt Fig. 1A das erste Substrat 110 mit einer Hauptseite 115 (z. B. eine der Hauptoberflächen eines Wafers), auf die einer Schichtstruktur 120 abgeschieden ist, so dass sich eine neue Oberfläche 117 ausbildet. Die Schichtstruktur 120 umfasst im Allgemeinen mehrere Schichten, wobei zwischen den mehreren Schichten (z.B. bis zu sechs Schichten) Kontaktierungsebenen oder Verbindungsstrukturen 130 (beispielsweise Metallisierungen) ausgebildet sein können. In dem Beispiel von Fig. 1A ist eine erste Verbindungsstruktur 130a (z.B. ein Gate Kontakt für einen FET) nahe der Oberfläche 115. Eine zweite Verbindungsstruktur 130b und eine dritte Verbindungsstruktur 130c sind ebenfalls in die Schichtstruktur 120 eingebettet. Im Allgemeinen sind die Verbindungsstrukturen 130 schichtförmig ausgebildet, so dass sie sich senkrecht zur Zeichenebene der Fig. 1A weiter erstrecken und über Durchkontaktierungen entweder miteinander oder mit dem Substrat 110 oder dotierten Bereiche in dem Substrat 110 verbunden sind. Die Verbindungsstrukturen 130 weisen leitfähiges Material auf, wie beispielsweise Metalle oder dotiertes halbleitermaterial. Das erste Substrat 110 weist beispielsweise Silizium auf und die erste Schichtstruktur 120 kann beispielsweise eine Schichtdicke von vier bis sechs Mikrometer aufweisen.

Die Fig. 1B zeigt einen Schritt, bei dem eine Durchkontaktierung 140 von der Oberfläche 117 zur dritten Verbindungsstruktur 130c ausgebildet und mit leitfähigem Material aufgefüllt wurde. Abschließend wurde auf der Oberfläche 117 eine Kontaktfläche 150 ausgebildet. Die Kontaktfläche 150 dient später zur vertikalen Kontaktierung einer zweiten Schaltungsstruktur, mit der sie in Verbindung gebracht wird.

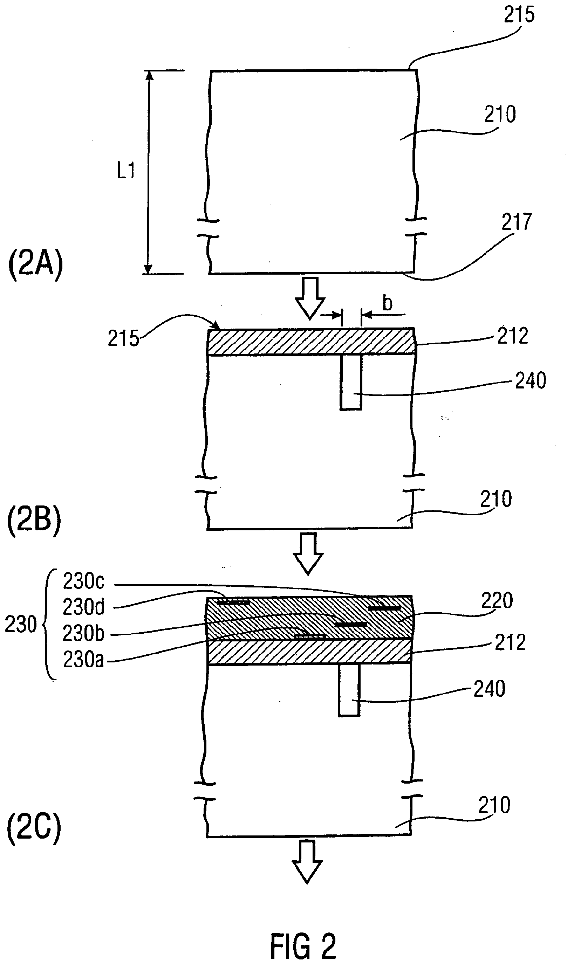

Die Fig. 2A bis 2E zeigen Querschnittsansichten für eine Schrittfolge zur Erzeugung der zweiten integrierten Schaltungsstruktur. Fg. 2A zeigt das zweite Substrat 210 mit einer Hauptseite 215 und einer gegenüberliegenden Seite 217, wobei das zweite Substrat 210 beispielsweise Silizium in einer Schichtdicke von ca. 780 µm umfassen kann.

Fig. 2B zeigt, wie in einem ersten Schritt eine Öffnung oder ein vertikaler Kontaktbereich 240 in dem zweiten Substrat 210 erzeugt wird, der sich senkrecht zu der Hauptseite 215 des zweiten Substrats 210 erstreckt. Daran anschließend wird eine epitaktische Schicht 212 auf der Hauptseite 215 des zweiten Substrats 210 ausgebildet. Bei dem epitaktischen Aufwachsen der Schicht 212 auf dem zweiten Substrat 210 ist es vorteilhaft, die Prozessführung derart zu gestalten, dass das Substratmaterial, welches epitaktisch auf dem zweiten Substrat 210 aufwächst, sich nicht in dem vertikalen Kontaktbereich 240 abscheidet, so dass der vertikale Kontaktbereich 240 von oben geschlossen wird - ohne den vertikalen Kontaktbereich 240 mit Substratmaterial zu schließen, so dass ein Hohlraum oder Hohlbereich weiterhin bestehen bleibt. Diese vorteilhafte Prozessführung kann beispielsweise dadurch erreicht werden, dass die Breitenausdehnung b des vertikalen Kontaktbereichs 240 so gewählt wird, dass sie kleiner ist als die mittlere freie Weglänge der epitaktisch aufwachsenden Atome des Substratmaterials. Damit kann sichergestellt werden, dass sich die Atome an der Oberfläche abscheiden, jedoch nicht in den vertikalen Kontaktbereich 240 hineingelangen können. Die epitaktische Schicht 212 kann beispielsweise eine Schichtdicke zwischen 50 und 100 µm aufweisen und der vertikale Kontaktbereich 240 kann als ein so genannter Through-Silicon-Via (TSV) herausgebildet werden.

Fig. 2C zeigt daran anschließende Prozessschritte, die beispielsweise ein Aufbringen einer zweiten Schichtstruktur 220 umfassen können. Die zweite Schichtstruktur 220 kann mehrere Schichten umfassen, zwischen denen elektrische Verbindungsebenen 230 eingebettet sind, wobei die elektrische Verbindungsebenen 230 beispielsweise leitfähiges Material oder dotiertes Halbleitermaterial umfassen können und die zweite Schichtstruktur 220 ein isolierendes Material (z.B. Oxid) aufweisen kann. In dem in Fig. 2C gezeigten Ausführungsbeispiel umfassen die Verbindungsstrukturen 230 vier Verbindungsstrukturen 230a bis 230d, die im Allgemeinen auf verschiedenen Ebenen in der zweiten Schichtstruktur 220 ausgebildet sind und sich wiederum senkrecht zur Zeichenebene erstrecken und miteinander verbunden sein können. Es kann ebenfalls eine Kontaktierung zu dem darunter liegenden Substrat oder der epitaktischen Schicht 212 ausgebildet sein. Die zweite Schichtstruktur 220 kann Schichten mit unterschiedlichen dielektrischem Material aufweisen, wobei oft die unterste dielektrische Schicht, die sich an die epitaktische Schicht 212 anschließt, ein dielektrisches Material mit einer niedrigen Dielektrizitätskonstante ε aufweist und häufig dünner ist als die sich daran anschließenden dielektrischen Schichten der zweiten Schichtstruktur 220.

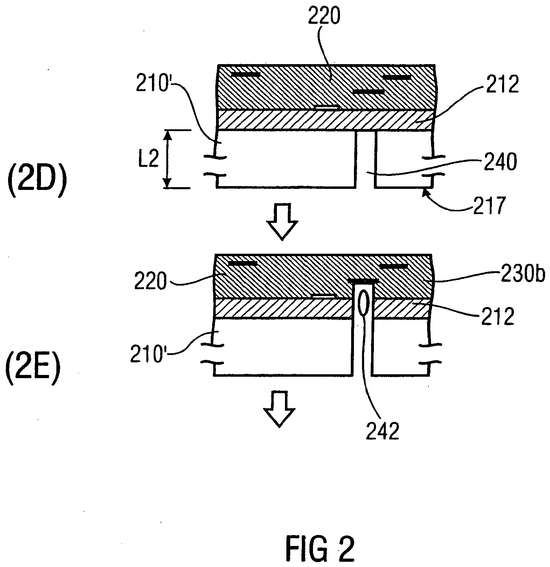

Fig. 2D zeigt, wie in einem Folgeschritt das zweite Substrat 210 von der gegenüberliegenden Seite 217 gedünnt wird, so dass gedünntes Substrat 210' entsteht. Die Dünnung des Substrats 210 kann beispielsweise durch ein Abtragen (z. B. Schleifen oder Ätzen) geschehen und verringert die Schichtdicke 11 des Substrats 210 auf eine Schichtdicke 12, die so gewählt werden kann, dass der vertikale Kontaktbereich 240 offen gelegt ist und sich somit auf der gegenüberliegenden Seite 217 eine Öffnung an der Stelle des vertikalen Kontaktbereichs 240 entsteht.

Fig. 2E zeigt, wie in einem Folgeschritt der vertikale Kontaktbereich 240 von der gegenüberliegenden Seite 217 weiter vertieft wird und zwar so lange, bis der vertikale Kontaktbereich 240 die zweite Verbindungsstruktur 230b erreicht. Dies kann beispielsweise durch einen Ätzprozess geschehen, bei dem die epitaktische Schicht 212 als auch ein zwischen der epitaktischen Schicht 212 und der zweiten Verbindungsstruktur 230b ausgebildete Teil der zweiten Schichtstruktur 220 entfernt wird. Dieser Ätzprozess kann ebenfalls in mehreren Schritten vonstatten gehen, bei denen beim ersten Schritt die epitaktische Schicht 212, die beispielsweise Silizium aufweist, geätzt wird und in einem Folgeschritt ein Ätzprozess verwendet wird, bei dem der Teil der Schichtstruktur 220 entfernt wird. In diesem Ätzprozess wirkt die zweite Verbindungsstruktur 230b als eine Stoppschicht, auf der der Ätzprozess stoppt. Vorzugsweise wird somit der Ätzprozess derart gewählt wird, dass er natürlich auf dem Material der zweiten Verbindungsstruktur 230b stoppt. Bei diesem Ätzprozess wird somit der vertikale Kontaktbereich 240 um einen weiteren Bereich 242 vergrößert oder erweitert. Daran anschließend kann der vertikale Kontaktbereich 240 mit leitfähigem Material aufgefüllt werden. Schließlich kann an der gegenüberliegenden Seite 217 ein Kontaktbereich ausgebildet werden.

Die Prozessführung, wie sie in den Figuren 2A bis 2E gezeigt ist, erfordert somit, dass der vertikale Kontaktbereich 240 und der zweite Teil der Verbindungsstruktur 230b zueinander justiert werden, damit eine elektrische Verbindung hergestellt werden kann. Dies kann beispielsweise derart geschehen, dass zum einen der vertikale Kontaktbereich an einer fixierten Stelle (wo später der zweite Teil der Verbindungsstruktur 230b ausgebildet wird) angeordnet wird. Anderseits kann auch der zweite Teil der Verbindungsstruktur 230b möglichst nahe (z.B. über) dem vertikalen Kontaktbereich 240 ausgebildet werden.

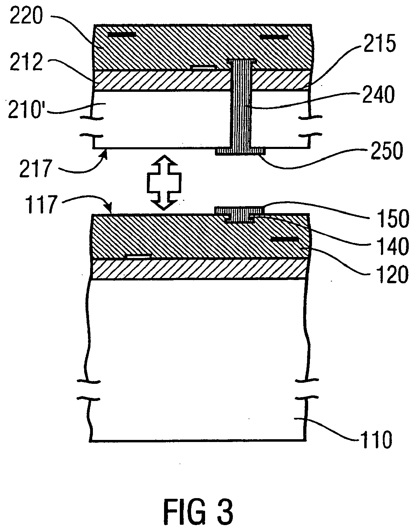

Fig. 3 zeigt zum einen das zweite gedünnte Substrats 210' mit der epitaktischen Schicht 212 und der zweiten Schichtstruktur 220, wobei der vertikale Kontaktbereich 240 mit leitfähigem Material aufgefüllt ist und entlang der gegenüberliegenden Seite 217 ein Kontaktbereich 250 angeordnet wurde. Zum anderen zeigt Fig. 3 das erste Substrat 110 mit der ersten Schichtstruktur 120, bei der auf der Hauptseite 117 die Kontaktfläche 150 ausgebildet ist. Das erste und zweite gedünnte Substrat 110 und 210' werden in dem Prozessschritt, der in Fig. 3 gezeigt ist, entlang der ersten Hauptseite 117 und der gegenüberliegenden Seite 217 zusammengebracht und zwar derart, dass der Kontaktbereich 250 mit der Kontaktfläche 150 kontaktiert werden und somit eine elektrische Verbindung hergestellt werden kann. Die Kontaktierung bzw. das Verbinden des Kontaktbereichs 250 mit der Kontaktfläche 150 kann dabei derart geschehen, dass es zu einer Interdiffusion kommt, so dass sich beide Materialien permanent miteinander verbinden. Dies ist beispielsweise dann der Fall, wenn die Materialien des Kontaktbereichs 250 und der Kontaktflächen 150 beispielsweise Zinn bzw. Kupfer aufweisen (oder alternativ Zinn bzw. Gold aufweisen). Die Interdiffusion geschieht unter Druck- und Temperatureinwirkung, die derart gewählt sind, dass eine eutektische Verbindung herausgebildet wird. Das leitfähige Material, mit dem der vertikale Kontaktbereich 240 und der weitere Bereich 242 aufgefüllt wird, kann beispielsweise Kupfer aufweisen.

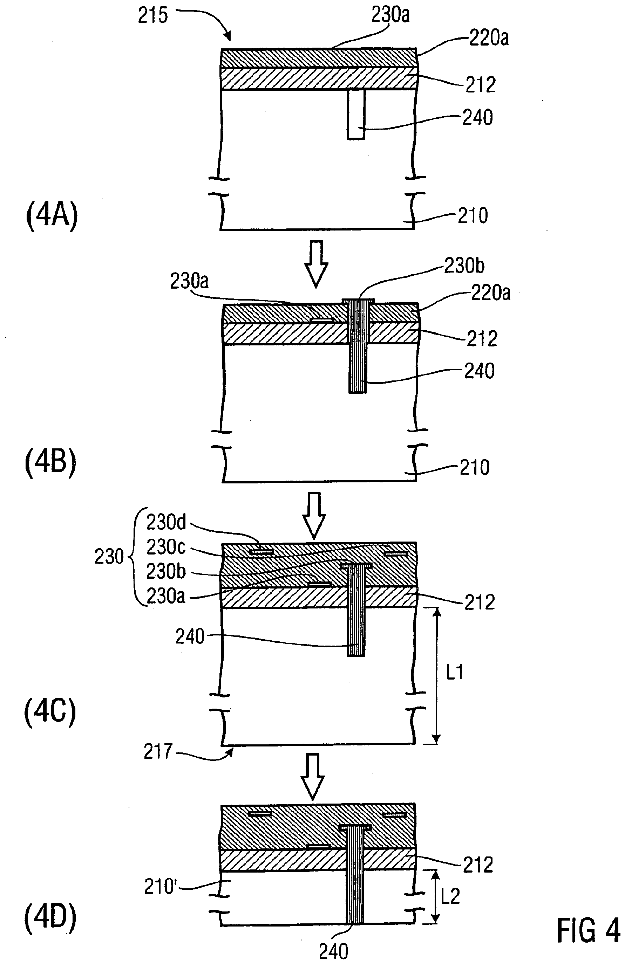

Die Fig. 4A bis 4D zeigen ein weiteres Ausführungsbeispiel für eine mögliche Prozessierung des zweiten Substrats 210, um die zweite integrierte Schaltungsstruktur herauszubilden. Ausgangspunkt bei dieser Prozessierung ist der Prozessschritt für das zweite Substrat 210 wie es in Fig. 2B gezeigt ist.

Fig. 4A zeigt das zweite Substrat 210 mit der epitaktischen Schicht 212, die an der Hauptseite 215 ausgebildet ist und den vertikalen Kontaktbereich 240 abdeckt. Bei dem Ausführungsbeispiel, das in den Fig. 4A bis 4D gezeigt ist, wird daran anschließend zunächst ein erster Teil der Schichtstruktur 220a auf der epitaktischen Schicht 212 ausgebildet. Der erste Teil der zweiten Schichtstruktur 220a kann beispielsweise einen ersten Teil der Verbindungsstruktur 230a aufweisen und beispielsweise ein Steuerkontakt eines für einen MOSFET umfassen kann. In diesem Fall sind in der epitaktischen Schicht 212 beispielsweise dotierte Bereiche (einen Senken- und einen Quellenbereich) ausgebildet.

Fig. 4B zeigt wie in einem Folgeschritt zunächst der erste Teil der Schichtstruktur 220a und die epitaktische Schicht 212 oberhalb des vertikalen Kontaktbereichs 240 geöffnet werden, so dass sich ein vergrößerter vertikaler Kontaktbereich 240 entsteht, der sowohl in dem Substrat 210 als auch in der epitaktischen Schicht 212 und dem ersten Teil der Schichtstruktur 220a ausgebildet ist. Daran anschließend kann der vertikale Kontaktbereich 240 mit leitfähigem Material (beispielsweise Kupfer) aufgefüllt werden. Dann wird ein zweiter Teil der Verbindungsstruktur 230b derart ausgebildet, dass der zweite Teil der Verbindungsstruktur 230b eine elektrische Verbindung mit dem mit elektrisch leitfähigem Material aufgefüllten vertikalen Kontaktbereich herstellt.

In Fig. 4C ist eine Querschnittsansicht des zweiten Substrats 210 und der epitaktischen Schicht 212 als auch der fertig prozessierten zweiten Schichtstruktur 220 gezeigt. Die zweite Schichtstruktur 220 kann dabei mehrere Schichten aufweisen, die mit elektrisch leitfähigen Verbindungsstrukturen 230 unterbrochen sein können. Diese Schichten können nacheinander auf die in Fig. 4B gezeigte Struktur aufgebracht werden. Konkret zeigt das Ausführungsbeispiel von Fig. 4C, dass neben dem bereits ausgebildeten ersten und zweiten Teil der Verbindungsstruktur 230a und 230b zusätzlich ein dritter und ein vierter Teil der Verbindungsstruktur 230c, 230d ausgebildet wird. Bei diesem Schritt der Prozessierung weist das zweite Substrat 210 die Schichtdicke von 11 auf, die in dem Folgeschritt von der gegenüberliegenden Seite 217 her gedünnt wird.

Fig. 4D zeigt das Resultat der Rückseitendünnung, d. h. das Resultat eines Abtragens von Substratmaterial des zweiten Substrats 210, so dass sich ein gedünntes zweite Substrat 210' herausbildet. Das gedünnte zweite Substrat 210' weist eine Schichtdicke 12 auf, die ihrerseits derart gewählt werden kann, dass der mit leitfähigem Material gefüllte vertikale Kontaktbereich 240 auf der gegenüberliegenden Seite 217 erscheint und kontaktierbar wird.

Dies bis dahin prozessierte gedünnte zweite Substrat 210' mit der zweiten integrierten Schaltungsstruktur kann wiederum mit einem Kontaktbereich an der gegenüberliegenden Seite 217 versehen werden, wobei der Kontaktbereich 250 (siehe Fig. 3) so positioniert wird, dass er in einem elektrischen Kontakt zu dem mit leitfähigem Material gefüllten vertikalen Kontaktbereich 240 steht. Wie in Fig. 3 gezeigt, kann das bis dahin prozessierte gedünnte zweite Substrat 210' mit dem ersten Substrat 110 miteinander verbunden werden, so dass der Kontaktbereich 250 mit der Kontaktfläche 150 einen elektrischen Kontakt bildet. Dazu kann wiederum ein Lötverfahren, das z.B. die Interdiffusion zur Ausbildung einer eutektischen Verbindung nutzt, verwendet werden.

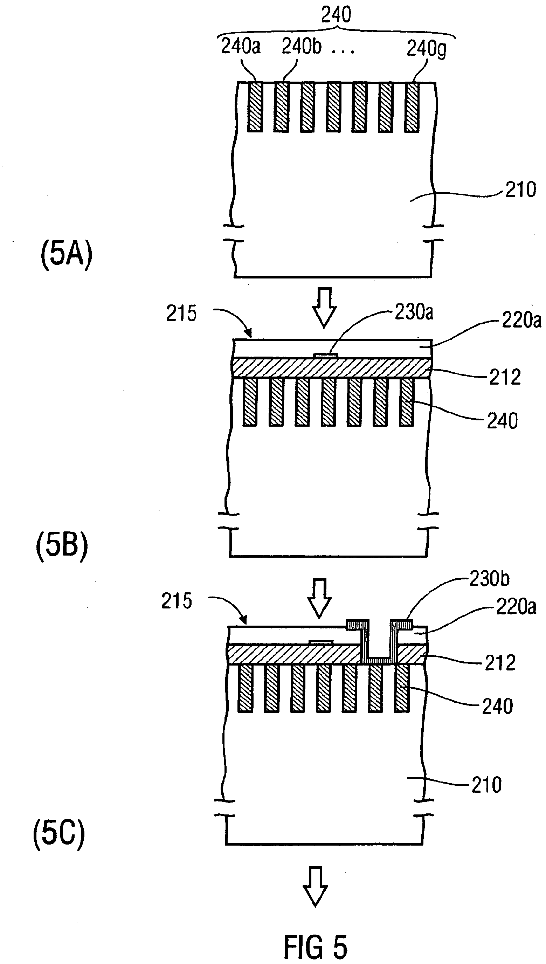

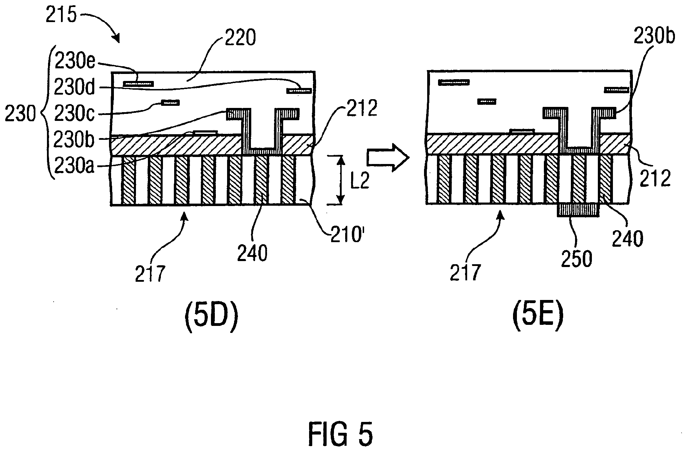

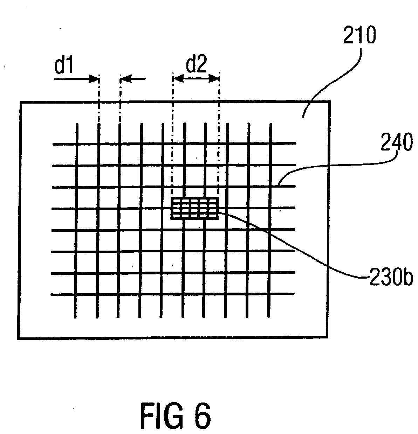

In den Fig. 5A bis 5E ist noch ein weiteres Ausführungsbeispiel gezeigt, das eine modifizierte Prozessführung für das zweite Substrat 210 aufweist. Bei der in der Fig. 5 dargestellten Prozessführung werden die vertikalen Kontaktbereiche 240 nach dem Erzeugen gleich mit leitfähigem Material aufgefüllt, so dass sich die in Fig. 5A gezeigte Struktur ergibt. Die Kontaktbereiche können beispielsweise wiederum mittels eines Ätzverfahrens erzeugt werden, das seinerseits eine geeignete Maske nutzt. In Fig. 5A ist ferner gezeigt, dass der vertikale Kontaktbereich 240 mehrere Bereiche 240a bis 240g aufweisen kann, die beispielsweise als Gräben oder Löcher oder Rastermuster ausgebildet sein können (siehe auch Fig. 6).

Fig. 5B zeigt, wie in einem Folgeschritt auf der Hauptseite (Hauptoberfläche) 215 zunächst die epitaktische Schicht 212 abgeschieden und daran anschließend ein erster Teil der zweiten Schichtstruktur 220a auf der epitaktischen Schicht 212 aufgebracht wird. Der erste Teil der zweiten Schichtstruktur 220a kann beispielsweise wiederum einen ersten Teil einer Verbindungsstruktur 230a aufweisen.

Fig. 5C zeigt, wie daran anschließend auf der Hauptseite 215 ein zweiter Teil der Verbindungsstruktur 230b ausgebildet wird und mit dem mit leitfähigem Material aufgefüllten vertikalen Kontaktbereich 240 kontaktiert wird. Dies kann derart geschehen, dass zunächst der erste Teil der zweiten Schichtstruktur 220a und die epitaktische Schicht 212 an der Stelle des zweiten Teils der Verbindungsstruktur 230b geöffnet werden. Dabei kann wiederum ein oder auch mehrere Ätzschritte genutzt werden, die schließlich auf dem Substrat 210 oder dem mit leitfähigem Material gefüllten vertikalen Kontaktbereich 240 stoppen. Nach dem Öffnen des ersten Teils der zweiten Schichtstruktur 220a und der epitaktischen Schicht 212 kann der zweite Teil der Verbindungsstruktur 230b in der entstehenden Öffnung ausgebildet werden, wobei sich der zweite Teil der Verbindungsstruktur 230b ebenfalls teilweise entlang (oder parallel zu) der Hauptseite 215 erstrecken kann.

In Fig. 5D ist gezeigt, wie auf die in Fig. 5C gezeigten Struktur der verbleibende Teil der zweiten Schichtstruktur 220 auf die Hauptseite 215 aufgebracht wird. Wie in den Ausführungsbeispielen zuvor auch, kann die zweite Schichtstruktur 220 mehrere Teile der Verbindungsstruktur 230 aufweisen (z. B. einen ersten bis fünften Teil 230a bis 230e). Ferner ist in Fig. 5D gezeigt, dass das Substrat 210 so weit von der gegenüberliegenden Seite 217 gedünnt wird, bis der mit leitfähigem Material aufgefüllte vertikale Kontaktbereich 240 an der gegenüberliegenden Seite 217 erscheint. Das gedünnte zweite Substrat 210' weist somit eine Schichtdicke 12 auf, wobei die Schichtdicke 12 kleiner oder gleich der Tiefe des vertikalen Kontaktbereiches 240 in der Fig. 5A ist.

Fig. 5E zeigt einen abschließenden Prozess, bei dem auf der gegenüberliegenden Seite 217 wiederum ein Kontaktbereich 250 ausgebildet wird, so dass eine elektrische Verbindung zwischen dem Kontaktbereich 250, den mit leitfähigem Material gefüllten vertikalen Kontaktbereich 240 und dem zweiten Teil der Verbindungsstruktur 230b hergestellt wird. Das derart prozessierte, zweite Substrat mit integrierter Schaltungsstruktur kann wiederum, wie in Fig. 3 gezeigt, mit dem ersten Substrat so zusammengebracht werden, dass der Kontaktbereich 250 den Kontaktfläche 150 des ersten Substrats 110 elektrisch kontaktiert.

Fig. 6 zeigt eine Draufsicht auf das zweite Substrat 210 von Fig. 5 mit den darin ausgebildeten vertikalen Kontaktbereichen 240, die sich senkrecht zur Zeichenebene in das zweite Substrat 210 hinein erstrecken. Wie in Fig. 6 gezeigt, kann der vertikale Kontaktbereich 240 verschiedene Formen aufweisen und insbesondere auch als ein Rastermuster ausgebildet sein (mögliche weitere Formen wären Gräben, Löcher oder auch ungleichmäßig geformte Bereiche). Wie in Fig. 5 gezeigt, ist es dabei vorteilhaft, wenn der Abstand benachbarter Gräben in dem wie in Fig. 6 gezeigten Rastermuster einen Abstand d1 aufweisen, der kleiner gewählt ist, als beispielsweise eine laterale Ausdehnung d2 des zweiten Teils der Verbindungsstruktur 230b. Damit ist sichergestellt, dass durch ein einfaches Öffnen des ersten Teils der zweiten Schichtstruktur 220a und der epitaktischen Schicht 212 (siehe Fig. 5C) immer ein Teil des vertikalen Kontaktbereichs 240 kontaktierbar wird. An dieser Stelle sei darauf hingewiesen, dass der zweite Teil der Verbindungsstruktur 230b senkrecht zur Zeichenebene in Fig. 6 von dem vertikalen Kontaktbereich 240 verschoben sein kann und insbesondere, dass ferner eine epitaktische Schicht 212 und ein erster Teil der Schichtstruktur 220a auf den vertikalen Kontaktbereich 240 ausgebildet sein kann. Die Ausbildung des vertikalen Kontaktbereichs 240 in der Form, wie es in Fig. 6 gezeigt ist, ist beispielsweise dahingehend vorteilhaft, dass eine Justage des zweiten Teils der Verbindungsstruktur 230b mit dem vertikalen Kontaktbereich 240 entfällt (wie es beispielsweise in der Fig. 2C als auch in der Fig. 2B erforderlich gewesen ist). Durch die gewählten Abmaße für d1 und d2 ist sichergestellt, dass ein Kontaktieren des vertikalen Kontaktbereiches 240 und des zweiten Teil des Verbindungsstruktur 230b erfolgt.

Bei weiteren Ausführungsbeispielen wird die in Fig. 5 beschriebene Prozessführung, nämlich das Auffüllen des vertikalen Kontaktbereichs 240 mit leitfähigem Material bevor die epitaktische Schicht 212 ausgebildet wird, auch für die Prozessführung genutzt, die in Fig. 2 und Fig. 4 beschrieben wurde. Somit kann zwischen Fig. 2A und 2B ein Zwischenschritt eingeführt werde, bei dem der vertikale Kotaktbereich 240 mit leitfähigem Material gefüllt wird. Der Schritt des Auffüllens mit leitfähigem Material kann auch dahingehend modifiziert werden, dass zunächst dielektrisches Material an den Seitenwänden und/oder Boden des vertikalen Kontaktbereiches 240 abgeschieden wird und erst danach ein Auffüllen mit leitfähigem Material erfolgt. Somit wäre das leitfähige Material seitlich von einer dielektrischen Schicht umgeben.

Ferner ist es möglich, einen Wafer mit einem als Raster ausgebildeten vertikalen Kontaktbereich 240 (wie in Fig. 6) separat zu prozessieren und mit leitfähigem Material aufzufüllen. Bei dem daran anschließenden Ausbilden von Bauelementen (Ausbilden von dotierten Gebieten in der epitaktischen Schicht oder in dem Substrat 210 als auch dem elektrischen Verbinden) kann das derart vorbereitete zweite Substrat 210 als Grundlage verwendet werden.

Bei weiteren Ausführungsbeispielen ist es ferner möglich, ein Muster für den vertikalen Kontaktbereich 240 derart zu erzeugen, dass es zwei oder mehr voneinander getrennte Gebiete umfasst, die für eine elektrische Kontaktierung mit einem darüber oder darunter angeordneten ersten Substrats dienen können, ohne dass die zwei oder mehr voneinander getrennte Gebiete eine elektrische Verbindung aufweisen.

Das Ausbilden der integrierten Schaltungsstruktur in dem ersten oder zweiten Substrat 110, 210 kann beispielsweise ein Ausbilden von dotierten Gebieten umfassen, die beispielsweise über Durchkontaktierungen mit den Verbindungsbereichen 230 verbunden werden, so dass sich elektrische Verbindungen zwischen verschiedenen dotierten Gebieten herausbilden können. Die dotierten Gebiete können sowohl in der epitaktischen Schicht 212 als auch in dem zweiten Substrat 210 oder dem ersten Substrat 110 ausgebildet werden. Die so erhaltenen integrierten Schaltungsstrukturen weisen die typische MOS-Struktur (MOS = metal oxide semiconductor) auf.

Bei weiteren Ausführungsbeispielen können auch so genannte SOI-Strukturen (SOI = semiconductor on isolator) entsprechend prozessiert werden. Bei derartigen Strukturen umfasst das zweite Substrat 210 beispielsweise zunächst einen Halbleiter, auf dem ein Isolator ausgebildet ist, auf dem wiederum ein Halbleiter ausgebildet sein kann, gefolgt von Schichtstruktur mit Verbindungsebenen (Metallisierung). Die erste und zweite Schichtstruktur 120 und 220 können beispielsweise andere isolierende Materialien aufweisen, wie beispielsweise Nitride, anstatt Oxide. Ferner kann die vertikale Herstellung unter Verwendung eines ersten und zweiten Substrats 110 und 210 dahingehend erweitert werden, dass weitere Substrate vertikal oder dreidimensional übereinander angeordnet werden. Dies kann beispielsweise einfach dadurch geschehen, dass das fertig prozessierte dreidimensional angeordnete Bauelement, wie es beispielsweise in Fig. 3 gezeigt ist, als ein weiteres erste Substrat genutzt wird, mit dem ein weiteres zweite Substrat vertikal in Verbindung gebracht wird.

Das erste Substrat 110 und das zweite Substrat 210 können bei der in den Fig. 1 bis 5 gezeigte Prozessführung Teile oder ganze Wafer umfassen, die beispielsweise vor dem Vereinzeln der Bauelemente (Dicing) vertikal oder dreidimensional prozessiert werden. Die epitaktische Schicht 212 kann beispielsweise ein gleiches Material aufweisen wie das zweite Substrat 210 (z. B. Silizium), wobei das Material des zweiten Substrats 220 auch eine poröse oder Schwammstruktur aufweisen kann und die epitaktische Schicht 212 eine wohl definierte Kristallstruktur definiert. Bei dem Aufbringen der epitaktischen Schicht 212 ist ferner darauf zu achten, dass die Temperatur so gewählt wird, dass die freie Weglänge der Atome der epitaktischen Schicht 212 größer ist als ein lateraler Durchmesser des vertikalen Kontaktbereichs 240, so dass die Atome nicht tiefer in den vertikalen Kontaktbereich 240 eindringen kann.

Ausführungsbeispiele bilden somit den vertikalen Kontaktbereich 240 während der Prozessierung der Bauelemente heraus. Damit werden gleich bei der Prozessierung die Verbindungsstrukturen (z.B. die zweite Verbindungsstrukturen 230b) korrekt kontaktiert. Somit ist nach dem rückseitigen Dünnen die Position der beispielhaften zweiten Verbindungsstruktur 230b bekannt und der offengelegte vertikale Kontaktbereich 240 kann zur Justage genutzt werden. Dies ist ein klarer Vorteil im Vergleich zu konventionellen verfahren, bei den das Ätzen beispielsweise erst nach der Prozessierung durchgeführt wird und bei denen es einen hohen Aufwand erfordert, die genaue Position der zu kontaktierenden beispielhaften zweiten Verbindungsstruktur 230a herauszufinden.

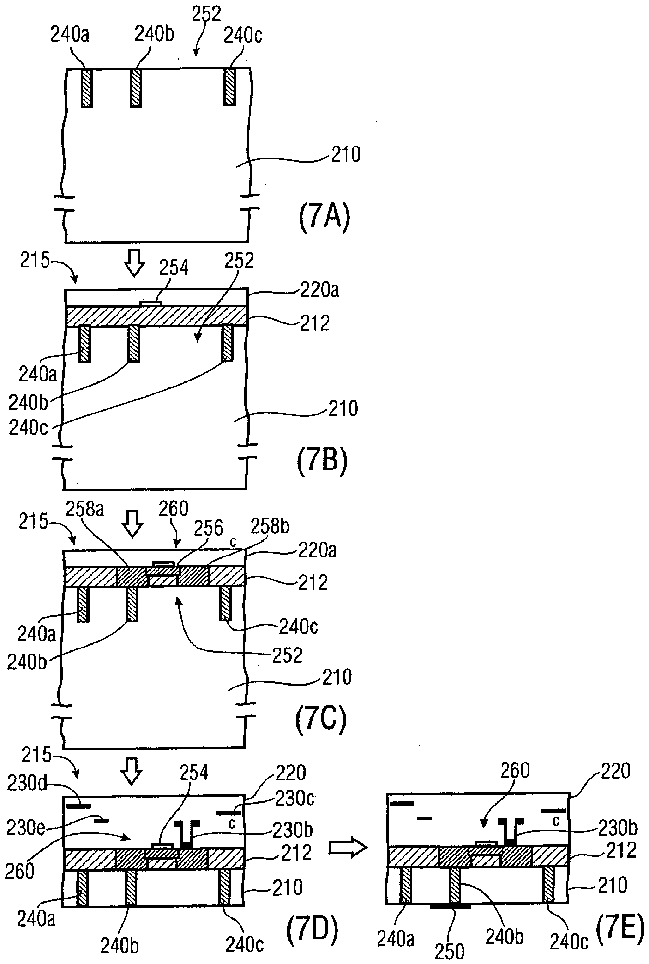

Eine alternative Vorgehensweise zu Fig. 5A bis 5E ist in den Fig. 7A bis 7E gezeigt, bei denen für funktionell übereinstimmende Elemente in den Figuren die gleichen Bezugszeichen verwendet wurden wir in Fig. 5A bis 5E, und bei denen die Beschreibung der Prozessschritte und der einzelnen Elemente bezüglich letzterer Figuren grundsätzlich auch für die Fig. 7A bis 7E zutreffen sollen, soweit sie nicht durch nachfolgende Beschreibung ersetzt werden.

Bei der Prozessführung nach Fig. 7A bis 7E erfolgt die elektrische Verbindung zwischen der Verbindungsstruktur 230 in der isolierenden Schichtstruktur 220 nicht durch eine Durchkontaktierung 230, wie z.B. eine mit Metall gefüllte bzw. mit Metall ausgekleidete, sich bis zu der der epitaktischen Schicht zugewandten Hauptseite des Substrats erstreckende Vertiefung. Vielmehr wird bei 7A die elektrische Verbindung über eine hochdotierte Zone der hier ja exemplarisch epitaktischen Halbleitschicht 212 hergestellt.

Insbesondere werden wie bei Fig. 5A zunächst vertikale Kontaktbereiche 240 erzeugt und nach dem Erzeugen mit leitfähigem Material aufgefüllt, so dass sich die in Fig. 7A gezeigte Struktur ergibt. Wie in Fig. 7A gezeigt kann der vertikale Kontaktbereich 240 mehrere Bereiche 240a bis 240c aufweisen. Sie können als Gräben, Löcher oder Rastermuster ausgebildet sein. Im unterschied zu der Darstellung nach Fig. 5A ist der Abstand zwischen denselben aber nicht regelmäßig. Vielmehr zeigt Fig. 7A eine Anordnung von Bereichen 240a bis 240c mit einer lateralen Aussparung 252 in einer ansonsten regelmäßigen Anordnung von Bereichen 240a bis 240c.

In einem Folgeschritt wird dann auf der Hauptseite des Substrats 210, an der die Kontaktbereiche 240a-c freiliegen die epitaktische Schicht 212 abgeschieden und daran anschließend ein erster Teil der zweiten Schichtstruktur 220a auf der epitaktischen Schicht 212 aufgebracht, und zwar so, dass der erste Teil der zweiten Schichtstruktur 220a als einen ersten Teil der Verbindungsstruktur einen über einen Gate-Oxid von der epitaktischen Schicht 212 getrennten Gate-Anschluss 254 aufweist. Durch beispielsweise Implantierungsverfahren werden dann einzelne Bereiche bzw. Zonen, die in Fig. 7C schraffiert dargestellt sind, hoch dotiert, und zwar so, dass sich unterhalb des Gate-Anschlusses 254 in der epitaktischen Schicht 212 ein Kanalbereich 256 ausbildet, der lateral an einen Source- und Drainbereich 258a bzw. 258b angrenzt, wodurch durch die Elemente 254-258b ein FET 260 gebildet wird. Die Source- und Drainbereiche 258a, 258b sind hochdotiert und erstrecken sich darüber hinaus bis zu der Hauptseite des Substrats 210, von der aus sich die Kontaktbereiche ins Innere des Substrats erstrecken. Einer der beiden Bereiche 258a,b ist mit einem 240b der Kontaktbereiche 240a-c elektrisch verbunden, während der andere im Bereich der Aussparung 252 liegt und somit nicht nach unten hin kontaktiert wird. Lediglich vorsichtshalber wird darauf hingewiesen, dass die in Fig. 7B und C gezeigte Reihenfolge bei der Herstellung der Struktur 220a und den Breichen 258a,b nicht zwingend so ist sondern umgedreht werden könnte.

Fig. 7d zeigt dann wie daran anschließend auf der Hauptseite 215 ein zweiter Teil der Verbindungsstruktur 230b in Form beispielsweise einer Durchkontaktierung oder mit Metall versehenen Vertiefung ausgebildet wird. Anders als bei den Ausführungsbeispiel von Fig. 5A bis 5E wird die Verbindungsstruktur lateral aber so positioniert, dass sie nicht etwa durch die epitaktische Schicht verläuft, um mit dem mit leitfähigem Material aufgefüllten vertikalen Kontaktbereich 240 kontaktiert zu sein, sondern die Verbindungsstruktur stellt lediglich die Verbindung zu dem anderen, von dem Kontaktbereich 240b unkontaktierten Source- bzw. Drain-Bereich 258b her. Ein Öffnen der epitaktischen Schicht 212 ist somit nicht notwendig, wodurch der laterale Platzbedarf für die Verbindungsstruktur 230b geringer als bei Fig. 5C sein kann.

Nach dem Öffnen des ersten Teils der zweiten Schichtstruktur 220a und der epitaktischen Schicht 212 kann wiederum ein zweiter Teil der Verbindungsstruktur 230b in der entstehenden Öffnung ausgebildet werden, wobei sich der zweite Teil der Verbindungsstruktur 230b ebenfalls teilweise entlang (oder parallel zu) der Hauptseite 215 erstrecken kann. Das Ergebnis ist in Fig. 7D gezeigt.

Fig. 7E zeigt einen abschließenden Prozess, bei dem auf der gegenüberliegenden Seite 217 wiederum ein Kontakt 250 ausgebildet wird, so dass über den Kontaktbereich 240b einerseits und den Transistor 260 andererseits eine elektrische Verbindung zwischen dem Kontakt 250 und dem zweiten Teil der Verbindungsstruktur 230b hergestellt wird. Das derart prozessierte, zweite Substrat mit integrierter Schaltungsstruktur kann wiederum, wie in Fig. 3 gezeigt, mit dem ersten Substrat so zusammengebracht werden, dass der Kontakt 250 den Kontaktfläche 150 des ersten Substrats 110 elektrisch kontaktiert.

Ähnlich dem Ausführungsbeispiel, das in den Figuren 7A bis 7E beschrieben ist, kann ebenfalls das Ausführungsbeispiel wie es in Fig. 2A bis 2E gezeigt ist, derart modifiziert werden, dass der vertikale Kontaktbereich 240 nicht den Teil der Verbindungsstruktur 230b kontaktiert, sondern stattdessen ein dotiertes Gebiet im Substrat 210 oder in der epitaktischen Schicht 212 kontaktiert wird. In diesem Fall braucht die epitaktische Schicht 212 nicht in dem Schritt aus Fig. 2E vollständig durchgeätzt werden, sondern ein Ätzen ist nur insofern erforderlich, wie es dem Kontaktieren des (hoch) dotierten Bereiches dient.

Also beschreiben obige Ausführungsbeispiele ein Verfahren zur Herstellung eines dreidimensionalen elektronischen Systems mit den Schritten des (a) Bereitstellens einer ersten integrierten Schaltungsstruktur in einem ersten Substrat, wobei die erste integrierte Schaltungsstruktur eine Kontaktfläche an einer ersten Hauptseite des ersten Substrats aufweist; (b) Bereitstellens eines zweiten Substrats mit einer Hauptseite; (c) Bildens einer Ausnehmung in dem zweiten Substrat von der Hauptseite, um einen vertikalen Kontaktbereich zu bilden; (d) nach Schritt (c) epitaktischen Aufwachsens einer Halbleiterschicht auf der Hauptseite des zweiten Substrats mit dem vertikalen Kontaktbereich; (e) Bildens eines Halbleiterbauelements einer zweiten integrierten Schaltungsstruktur in dem zweiten Substrat mit der Halbleiterschicht, wobei die Halbleiterschicht als Substratschicht für das Halbleiterbauelement dient; (f) Entfernens von Substratmaterial von einer der Hauptseite gegenüberliegenden Seite des zweiten Substrats, so dass der vertikale Kontaktbereich an der gegenüberliegenden Seite elektrisch freigelegt wird; und (g) aufeinander Anordnens des ersten und zweiten Substrats unter Ausrichtung des vertikalen Kontaktbereichs mit der Kontaktfläche, so dass eine elektrische Verbindung zwischen der ersten und zweiten integrierten Schaltungsstruktur über den vertikalen Kontaktbereich und die Kontaktfläche hergestellt wird.

Der Schritt des Bildens des vertikalen Kontaktbereichs kann derart ausgeführt werden, dass eine elektrische Verbindung zu dem Halbleiterbauelement der zweiten integrierten Schaltungsstruktur hergestellt wird, wobei dann das Bilden der elektrischen Verbindung zu dem Halbleiterbauelement der zweiten integrierten Schaltungsstruktur ein Kontaktieren eines hoch dotierten Halbleitermaterials umfasst, und der Schritt des Kontaktierens ein Kontaktieren des hoch dotierten Halbleitermaterials durch den vertikalen Kontaktbereich umfasst.

Nach dem Schritt (e) kann ein Schritt des Ausbildens zumindest eines Teils einer dielektrischen Schichtstruktur auf der Halbleiterschicht ausgeführt werden, wobei der Schritt des Ausbildens zumindest eines Teils der dielektrischen Schichtstruktur ein Bilden einer Verbindungsstruktur umfasst. Dabei kann der Schritt des Bildens der Verbindungsstruktur ein Ausbilden einer Metallisierungsebene umfassen und die Metallisierungsebene einen Kontakt zu dem Halbleiterbauelement der zweiten integrierten Schaltungsstruktur aufweisen, oder der Schritt des Bildens der Verbindungsstruktur kann ein Justieren eines Teils der Verbindungsstruktur gegenüber dem vertikalen Kontaktbereichs oder der Schritt des Bildens des vertikalen Kontaktbereichs ein Justieren gegenüber dem Teil der Verbindungsstruktur umfassen, so dass der Teil der Verbindungsstruktur und der vertikale Kontaktbereich zueinander lateral ausgerichtet sind.

Das Ausbilden zumindest eines Teils der dielektrischen Schichtstruktur kann ein Ausbilden einer Oxidschicht umfassen. Ferner kann der Schritt (c) ein Bilden einer Ausnehmung senkrecht zur Hauptseite umfassen.

Zwischen dem Schritt (f) und dem Schritt (g) kann ein Schritt eines Erweiterns der Ausnehmung derart ausgeführt werden, dass über die so entstehende Ausnehmung ein Teil der Verbindungsstruktur freigelegt wird, und ferner einen Schritt eines Auffüllens der Ausnehmung mit leitfähigem Material umfasst, so dass ein elektrischer Kontakt zu dem Teil der Verbindungsstruktur hergestellt wird, wobei dabei das Verfahren ferner ein Ausbilden eines weiteren Kontaktbereichs an der gegenüberliegenden Seite umfassen und die weitere Kontaktfläche in dem Schritt (g) mit der Kontaktfläche elektrisch kontaktiert werden kann.

Die Kontaktfläche und/oder eine weiteren Kontaktfläche können unter Verwendung von Kupfer und/oder Zinn gebildet werden.

Der Schritt kann ein Bilden einer Ausnehmung für den vertikalen Kontaktbereich und ein Auffüllen der Ausnehmung mit leitfähigem Material umfassen, wobei dabei ein Schritt des Öffnens der Halbleiterschicht nach dem Schritt (d) ausgeführt und ein Schritt des Aufbringens von leitfähigem Material auf die geöffnete Halbleiterschicht ausgeführt werden können, um einen Teil der Verbindungsstruktur zu bilden, wobei eine elektrische Verbindung zu dem mit leitfähigem Material gefüllten vertikalen Kontaktbereich hergestellt wird, und wobei dabei der Schritt (d) ein Ausbilden eines Teils einer dielektrischen Schichtstruktur umfassen und der Schritt des Öffnens der Halbleiterschicht ein Öffnen eines Teils der dielektrischen Schichtstruktur umfassen kann.

Das Verfahren kann ferner einen Schritt des Auffüllens des vertikalen Kontaktbereichs mit Wolfram umfassen.

Der Schritt des Bildens des vertikalen Kontaktbereichs kann ein Bilden einer regelmäßigen Gräbenanordnung umfassen, so dass ein Abstand (d1) zwischen benachbarten Gräben höchstens einer lateralen Ausdehnung (d2) des Teils der Verbindungsstruktur entspricht, wobei der Schritt des Ausbildens des Teils der Verbindungsstruktur und die Bildung des vertikalen Kontaktbereiches zueinander unjustiert erfolgen.

Der Schritt des Bildens des vertikalen Kontaktbereichs, der Schritt des Bildens des Halbleiterbauelements und der Schritt des aufeinander Ausrichtens können derart durchgeführt werden, dass die elektrische Verbindung so hergestellt wird, dass sich der vertikale Kontaktbereich von der Kontaktfläche bis zu einem hochdotierten Bereich der Halbleiterschicht erstreckt, der wiederum an der Hauptseite des Substrats angrenzt, wobei der Schritt des Bildens des Halbleiterbauelements derart durchgeführt wird, dass der hochdotierte Bereich der Halbleiterschicht einen eines Drain- und Source-Bereichs eines Transistors bildet, und der Schritt (e) ferner ein Ausbilden einer dielektrischen Schichtstruktur mit einer Metallisierungsebene auf der Halbleitschicht umfasst, die über eine Durchkontaktierung mit dem jeweils anderen des Drain- und Source-Bereichs des Transistors verbunden ist.

Der Schritt (g) kann ein Interdiffusionsverfahren umfassen, das die elektrische Verbindung zwischen der ersten und zweiten Schaltungsstruktur herstellt.

Der Schritt des Bildens des vertikalen Kontaktbereichs und/oder der Schritt des Entfernens von Substratmaterial können einen Ätzprozess umfassen.

Der Schritt (c) des Bildens des vertikalen Kontaktbereichs kann ein Verwenden von Kupfer umfassen.

## Patentansprüche

1. Verfahren zur Herstellung eines dreidimensionalen elektronischen Systems mit folgenden Schritten:
(a) Bereitstellen einer ersten integrierten Schaltungsstruktur in einem ersten Substrat (110), wobei die erste integrierte Schaltungsstruktur eine Kontaktfläche (150) an einer ersten Hauptseite (117) des ersten Substrats (110) aufweist;
(b) Bereitstellen eines zweiten Substrats (210) mit einer Hauptseite (215);
(c) Bilden einer Ausnehmung in dem zweiten Substrat (210) von der Hauptseite (215), und Auffüllen der Ausnehmung mit leitfähigem Material, um einen vertikalen Kontaktbereich (240) zu bilden;
(d) nach Schritt (c), epitaktisches Aufwachsen einer Halbleiterschicht (212) auf der Hauptseite (215) des zweiten Substrats (210) mit dem vertikalen Kontaktbereich (240) vermittels eines Wachstumsprozesses, bei dem Substratmaterial unter Einhaltung der Gitterstruktur aufwächst;
(e) Bilden eines Halbleiterbauelements einer zweiten integrierten Schaltungsstruktur in der Halbleiterschicht (212);
(f) Entfernen von Substratmaterial von einer der Hauptseite (215) gegenüberliegenden Seite (217) des zweiten Substrats (210), so dass der vertikale Kontaktbereich (240) an der gegenüberliegenden Seite (217) elektrisch freigelegt wird;
(g) aufeinander Anordnen des ersten und zweiten Substrats (110, 210) unter Ausrichtung des vertikalen Kontaktbereichs (240) mit der Kontaktfläche (150), so dass eine elektrische Verbindung zwischen der ersten und zweiten integrierten Schaltungsstruktur über den vertikalen Kontaktbereich (240) und die Kontaktfläche (150) hergestellt wird.

2. Verfahren zur Herstellung eines dreidimensionalen elektronischen Systems mit folgenden Schritten:
(a) Bereitstellen einer ersten integrierten Schaltungsstruktur in einem ersten Substrat (110), wobei die erste integrierte Schaltungsstruktur eine Kontaktfläche (150) an einer ersten Hauptseite (117) des ersten Substrats (110) aufweist;
(b) Bereitstellen eines zweiten Substrats (210) mit einer Hauptseite (215);
(c) Bilden einer Ausnehmung in dem zweiten Substrat (210) von der Hauptseite (215);
(d) nach Schritt (c), epitaktisches Aufwachsen einer Halbleiterschicht (212) auf der Hauptseite (215) des zweiten Substrats (210) mit dem vertikalen Kontaktbereich (240) vermittels eines Wachstumsprozesses, bei dem Substratatome unter Einhaltung der Gitterstruktur aufwachsen, wobei eine Öffnungsbreite der Ausnehmung kleiner ist als eine mittlere freie Weglänge der Substratatome, die sich beim epitaktischen Aufwachsen auf dem zweiten Substrat unter Einhaltung der Gitterstruktur anordnen, so dass die Halbleiterschicht (212) die Ausnehmung bedeckt;
(e) Bilden eines Halbleiterbauelements einer zweiten integrierten Schaltungsstruktur in der Halbleiterschicht (212);
(f1) Entfernen von Substratmaterial von einer der Hauptseite (215) gegenüberliegenden Seite (217) des zweiten Substrats (210), so dass die Ausnehmung an der gegenüberliegenden Seite (217) geöffnet wird;
(f2) Auffüllen der Öffnung mit leitfähigem Material, um einen vertikalen Kontaktbereich (240) zu bilden; und
(g) aufeinander Anordnen des ersten und zweiten Substrats (110, 210) unter Ausrichtung des vertikalen Kontaktbereichs (240) mit der Kontaktfläche (150), so dass eine elektrische Verbindung zwischen der ersten und zweiten integrierten Schaltungsstruktur über den vertikalen Kontaktbereich (240) und die Kontaktfläche (150) hergestellt wird.

3. Verfahren nach Anspruch 2, bei dem nach dem Schritt (e) ferner ein Ausbilden zumindest einer dielektrischen Schichtstruktur (220) auf der Halbleiterschicht (212)stattfindet, die mehrere Schichten umfasst, zwischen denen eine elektrische Verbindungsebene (230) eingebettet ist, und zwar so, dass die elektrische Verbindungsebene einen Kontakt zu dem Halbleiterbauelement der zweiten integrierten Schaltungsstruktur aufweist, wobei die Schritte (c) bis (g) so durchgeführt werden, dass über die elektrische Verbindungsebene (230) eine elektrische Verbindung zwischen dem vertikalen Kontaktbereich und dem Halbleiterbauelement der zweiten integrierten Schaltungsstruktur hergestellt wird, indem das Verfahren zwischen dem Schritt (f) und dem Schritt (g) ein Vertiefen der Ausnehmung (240) bis zu der elektrischen Verbindungsebene (230) aufweist.

4. Verfahren nach Anspruch 2, bei dem zwischen den Schritten (d) und (f2) ein Öffnen der Halbleiterschicht (212) derart durchgeführt wird, dass die geöffnete epitaktische Schicht (212) die Ausnehmung freilegt.

5. Verfahren nach Anspruch 4, bei dem nach dem Schritt (f2) ferner ein Ausbilden eines Teils einer Verbindungsstruktur (230b) in vertikaler Richtung oberhalb der Ausnehmung derart ausgeführt wird, dass der Teil der Verbindungsstruktur (230b) eine elektrische Verbindung mit dem mit leitfähigem Material aufgefüllten vertikalen Kontaktbereich (240) herstellt.

6. Verfahren nach einem der Ansprüche 1 bis 5, bei dem die Schritte (c) bis (g) so durchgeführt werden, dass eine elektrische Verbindung zu dem Halbleiterbauelement der zweiten integrierten Schaltungsstruktur hergestellt wird.

7. Verfahren nach Anspruch 6, bei dem die Schritte (c) bis (g) so durchgeführt werden, dass die elektrische Verbindung zu dem Halbleiterbauelement der zweiten integrierten Schaltungsstruktur ein Kontaktieren des vertikalen Kontaktbereichs (240) mit einem hoch dotierten Halbleitermaterial des Halbleiterbauelements umfasst.

8. Verfahren nach einem der vorhergehenden Ansprüche, bei dem die Ausnehmung eine Seitenwand aufweist und das Verfahren ferner ein Bilden einer dielektrischen Isolierschicht an der Seitenwand der Ausnehmung umfasst.

9. Verfahren nach einem der vorhergehenden Ansprüche, bei dem mehrere vertikale Kontaktbereiche (240) in Form einer regelmäßigen Gräbenanordnung gebildet werden.

10. Verfahren nach einem der Ansprüche 1 bis 9, bei dem der Schritt des Bildens des vertikalen Kontaktbereichs (240), der Schritt des Bildens des Halbleiterbauelements und der Schritt des aufeinander Ausrichtens derart durchgeführt werden, dass die elektrische Verbindung so hergestellt wird, dass sich der vertikale Kontaktbereich (240) von der Kontaktfläche (150) bis zu einem hochdotierten Bereich der Halbleiterschicht erstreckt, der wiederum an der Hauptseite (215) des Substrats angrenzt.

11. Integrierte elektronische Schaltungsanordnung eines dreidimensionalen elektronischen Systems, mit:
einem ersten Substrat (110) mit einer ersten integrierten Schaltungsstruktur und einer Hauptseite (117), auf die eine erste dielektrische Schichtstruktur (120) mit einer ersten Kontaktfläche (150) angeordnet ist, wobei in der ersten dielektrischen Schichtstruktur (120) eine Verbindungsstruktur (130) ausgebildet ist, die über erste Durchkontaktierungen (140) mit der ersten Kontaktfläche (150) und dotierten Bereichen in dem ersten Substrat (110) elektrisch verbunden ist;
einem zweiten gedünnten Substrat (210') mit einer zweiten integrierten Schaltungsstruktur und einer Hauptseite (215), auf der eine vermittels eines Wachstumsprozesses unter Einhaltung der Gitterstruktur des zweiten Substrats aufgewachsene epitaktische Halbleiterschicht (212), eine zweite dielektrische Schichtstruktur (220) und eine zweite Kontaktfläche (250) ausgebildet sind, wobei die epitaktische Halbleiterschicht (212) zwischen der zweiten dielektrischen Schichtstruktur (220) und dem gedünnten Substrat (210') angeordnet ist, die dielektrische Schicht (220 eine zweite Verbindungsstruktur (230b) aufweist, die über zweite Durchkontaktierungen mit dotierten Bereichen in dem zweiten Substrat (210) oder in der epitaktischen Halbleiterschicht (212) elektrisch verbunden ist, und die zweite Kontaktfläche (250) auf einer der Hauptseite (215) des zweiten Substrats (210) abgewandten Seite der zweiten dielektrischen Schichtstruktur (220) angeordnet ist; und
einem vertikalen Kontaktbereich zum Herstellen eines elektrischen Kontakts zwischen der zweiten Verbindungsstruktur (230b) und der zweiten Kontaktfläche (250),
wobei der vertikale Kontaktbereich (240) eine regelmäßige Gräbenanordnung aufweist, wobei ein Abstand (d1) benachbarter Gräben der regelmäßigen Gräbenanordnung kleiner ist als eine laterale Ausdehnung (d2) einer dritten Durchkontaktierung oder einer mit Metall versehenen Vertiefung (230b), über die die zweite Verbindungsstruktur (230) mit dem vertikalen Kontaktbereich verbunden ist,
und wobei die erste Kontaktfläche (150) und die zweite Kontaktfläche (250) elektrisch und mechanisch miteinander verbunden sind.

12. Integrierte elektronische Schaltungsanordnung nach Anspruch 11, bei dem sich der vertikale Kontaktbereich (240) durch das gedünnte zweite Substrat (210'), die Halbleiterschicht (212) und einen ersten Teil der dielektrischen Schichtstruktur (220a) erstreckt.

13. Integrierte elektronische Schaltungsanordnung nach Anspruch 11 oder Anspruch 12, bei dem der vertikale Kontaktbereich (240) und der erste Kontaktbereich (140) derart ausgebildet sind, dass ein Stromfluss von der ersten Verbindungsstruktur (230b) und der zweiten Verbindungsstruktur (130) nur entlang einer Richtung erfolgt und die Verbindungsstrukturen (230, 130) Metallisierungsebenen einer MOS-Struktur sind.

14. Integrierte elektronische Schaltungsanordnung nach einem der Ansprüche 11 bis 13, bei dem die regelmäßige Gräbenanordnung des vertikalen Kontaktbereichs (240) ein translationssymmetrisches Raster aufweist.

15. Integrierte elektronische Schaltungsanordnung nach einem der Ansprüche 11 bis 14, bei dem der vertikale Kontaktbereich (240) Wolfram aufweist und/oder die zweite Kontaktfläche (250) Zinn oder Kupfer aufweist.

## Claims

1. A method for manufacturing a three-dimensional electronic system, comprising:
(a) providing a first integrated circuit structure in a first substrate (110), wherein the first integrated circuit structure comprises a contact pad (150) at a first main side (117) of the first substrate (110);
(b) providing a second substrate (210) with a main side (215);
(c) forming a recess in the second substrate (210) from the main side (215) and filling the recess with conductive material to form a vertical contact area (240);
(d) after step (c), epitaxial growth of a semiconductor layer (212) on the main side (215) of the second substrate (210) with the vertical contact area (240) by means of a growth process, wherein the substrate material is grown while maintaining the lattice structure;
(e) forming a semiconductor device of a second integrated circuit structure in the semiconductor layer (212);
(f) removing substrate material from a side (217) of the second substrate (210) opposite to the main side (215), so that the vertical contact area (240) at the opposite side (217) is electrically exposed;
(g) arranging the first and second substrates (110, 210) on top of each other while aligning the vertical contact area (240) with the contact pad (150), so that an electrical connection between the first and second integrated circuit structures is established via the vertical contact area (240) and the contact pad (150).

2. A method for manufacturing a three-dimensional electronic system, comprising:
(a) providing a first integrated circuit structure in a first substrate (110), wherein the first integrated circuit structure comprises a contact pad (150) at a first main side (117) of the first substrate (110);
(b) providing a second substrate (210) with a main side (215);
(c) forming a recess in the second substrate (210) from the main side (215);
(d) after step (c), epitaxial growth of a semiconductor layer (212) on the main side (215) of the second substrate (210) with the vertical contact area (240) by means of a growth process, wherein substrate atoms are grown while maintaining the lattice structure, wherein an opening width of the recess is smaller than an average free path length of the substrate atoms that are arranged on the second substrate during epitaxial growth while maintaining the lattice structure, such that the semiconductor layer (212) covers the recess;
(e) forming a semiconductor device of a second integrated circuit structure in the semiconductor layer (212);
(f1) removing substrate material from a side (217) of the second substrate (210) opposite to the main side (215), so that the recess at the opposite side (217) is opened;
(f2) filling the opening with conductive material to form a vertical contact area (240);
(g) arranging the first and second substrates (110, 210) on top of each other while aligning the vertical contact area (240) with the contact pad (150), so that an electrical connection between the first and second integrated circuit structures is established via the vertical contact area (240) and the contact pad (150).

3. The method according to claim 2, wherein after step (e), further, forming at least one dielectric layer structure (220) on the semiconductor layer (212) takes place, which includes several layers between which an electrical connecting plane (230) is embedded, such that the electrical connecting plane (230) comprises a contact to the semiconductor device of the second integrated circuit structure, wherein the steps (c) to (g) are performed such that an electrical connection between the vertical contact area and the semiconductor device of the second integrated circuit structure is established via the electric connecting plane (230), in that the method comprises, between the step (f) and the step (g), deepening of the recess (240) up to the electrical connecting plane (230).

4. The method according to claim 1, wherein between the steps (d) and (f2) an opening of the semiconductor layer (212) is performed such that the opened epitaxial layer (212) exposes the recess.

5. The method according to claim 4, wherein after the step (f2) further forming a part of a connecting structure (230b) in vertical direction above the recess is performed such that the part of the connecting structure (230b) establishes an electrical connection to the vertical contact area (240) filled with the conductive material.

6. The method according to one of claims 1 to 5, wherein the steps (c) to (g) are performed such that an electrical connection to the semiconductor device of the second integrated circuit structure is established.

7. The method according to claim 6, wherein the steps c) to g) are performed such that the electrical connection to the semiconductor device of the second integrated circuit structure includes contacting the vertical contact area (240) with a heavily doped semiconductor material of the semiconductor device.

8. The method according to one of the preceding claims, wherein the recess comprises a side wall and the method further comprises forming a dielectric insulating layer at the side wall of the recess.

9. The method according to one of the preceding claims, wherein several vertical contact areas (240) are formed in the shape of a regular trench arrangement.

10. The method according to one of claims 1 to 9, wherein the step of forming the vertical contact area (240), the step of forming the semiconductor device and the step of adjusting to each other are performed such that the electrical connection is established such that the vertical contact area (240) extends from the contact pad (150) to a heavily doped area of the semiconductor layer which is again adjacent to the main side (215) of the substrate.

11. An integrated electronic circuitry of a three-dimensional electronic system, comprising:
a first substrate (110) with a first integrated circuit structure and a main side (117) on which a first dielectric layer structure (120) with a first contact pad (150) is arranged, wherein in the first dielectric layer structure (120) a connecting structure (130) is formed that is electrically connected to the first contact pad (150) and doped areas in the first substrate (110) via first vias (140);
a second thinned substrate (210') with a second integrated circuit structure and a main side (215) on which an epitaxial semiconductor layer (212) grown by means of a growth process while maintaining the lattice structure of the second substrate, a second dielectric layer structure (220) and a second contact pad (250) are formed, wherein the epitaxial semiconductor layer (212) is arranged between the second dielectric layer structure (220) and the thinned substrate (210'), the dielectric layer (220) comprises a second connecting structure (230b) that is electrically connected to doped areas in the second substrate (210) or in the epitaxial semiconductor layer (212) via second vias, and the second contact pad (250) is arranged on a side of the second dielectric layer structure (220) facing away from the main side (215) of the second substrate (210);
a vertical contact area (240) for establishing an electrical contact between the second connecting structure (230) and the second contact pad (250),
wherein the vertical contact area (240) comprises a regular trench arrangement, wherein a distance (d1) of adjacent trenches of the regular trench arrangement is smaller than a lateral extension (d2) of a third via or a recess (230b) provided with metal, via which the second connecting structure (230) is connected to the vertical contact area,
and wherein the first contact pad (150) and the second contact pad (250) are electrically and mechanically connected to each other.

12. The integrated, electronic circuitry according to claim 11, wherein the vertical contact area (240) extends through the thinned second substrate (210'), the semiconductor layer (212) and a first part of the dielectric layer structure (220a).

13. The integrated, electronic circuitry according to claims 11 or 12, wherein the vertical contact area (240) and the first contact area (140) are implemented such that a current flow from the first connecting structure (230b) and the second connecting structure (130) only takes place along one direction and the connecting structures (230, 130) are metallization planes of an MOS structure.

14. The integrated, electronic circuitry according to one of claims 11 to 13, wherein the regular trench arrangement of the vertical contact area (240) comprises a translation-symmetrical raster.

15. The integrated, electronic circuitry according to one of claims 11 to 14, wherein the vertical contact area (240) comprises tungsten and/or the second contact pad (250) comprises tin or copper.

## Revendications

1. Procédé de fabrication d'un système électronique tridimensionnel, aux étapes suivantes consistant à:
(a) préparer une première structure de circuit intégré dans un premier substrat (110), la première structure de circuit intégré présentant une surface de contact (150) sur une première face principale (117) du premier substrat (110);
(b) préparer un deuxième substrat (210) avec une face principale (215);
(c) former un évidement dans le deuxième substrat (210) à partir de la face principale (215), et remplir l'évidement de matériau conducteur pour former une zone de contact verticale (240);
(d) après l'étape (c), cultiver de manière épitaxiale une couche semi-conductrice (212) sur la face principale (215) du deuxième substrat (210) avec la zone de contact verticale (240) au moyen d'un processus de croissance dans lequel du matériau de substrat croît tout en préservant la structure de grille;
(e) former un composant semi-conducteur d'une deuxième structure de circuit intégré dans la couche semi-conductrice (212);
(f) éliminer du matériau de substrat d'une face (217) du deuxième substrat (210) opposée à la face principale (215), de sorte que la zone de contact verticale (240) soit exposée électriquement sur la face opposée (217);
(g) disposer l'un sur l'autre le premier et le deuxième substrat (110, 210) tout en alignant la zone de contact verticale (240) sur la surface de contact (150) de sorte que soit établie une connexion électrique entre la première et la deuxième structure de circuit intégré par l'intermédiaire de la zone de contact verticale (240) et de la surface de contact (150).

2. Procédé de fabrication d'un système électronique tridimensionnel, aux étapes suivantes consistant à:
(a) préparer une première structure de circuit intégré dans un premier substrat (110), la première structure de circuit intégré présentant une surface de contact (150) sur une première face principale (117) du premier substrat (110);
(b) préparer un deuxième substrat (210) avec une face principale (215);
(c) former un évidement dans le deuxième substrat (210) à partir de la face principale (215);
(d) après l'étape (c), cultiver de manière épitaxiale une couche semi-conductrice (212) sur la face principale (215) du deuxième substrat (210) avec la zone de contact verticale (240) au moyen d'un processus de croissance dans lequel des atomes de substrat croissent tout en préservant la structure de grille, une largeur d'ouverture de l'évidement étant inférieure à une longueur de trajet libre moyenne des atomes de substrat qui se disposent lors de la croissance épitaxiale sur le deuxième substrat tout en préservant la structure de grille, de sorte que la couche semi-conductrice (212) recouvre l'évidement;
(e) former un composant semi-conducteur d'une deuxième structure de circuit intégré dans la couche semi-conductrice (212);
(f1) éliminer du matériau de substrat d'une face (217) du deuxième substrat (210) opposée à la face principale (215), de sorte que l'évidement soit ouvert sur la face opposée (217) ;
(f2) remplir l'ouverture de matériau conducteur pour former une zone de contact verticale (240); et
(g) disposer l'un sur l'autre le premier et le deuxième substrat (110, 210) tout en alignant la zone de contact verticale (240) sur la surface de contact (150) de sorte que soit établie une connexion électrique entre la première et la deuxième structure de circuit intégré par l'intermédiaire de la zone de contact verticale (240) et de la surface de contact (150).

3. Procédé selon la revendication 2, dans lequel a lieu, après l'étape (e), par ailleurs une formation d'au moins une structure de couche diélectrique (220) sur la couche semi-conductrice (212) qui comporte plusieurs couches entre lesquelles est incorporé un plan de connexion électrique (230), et ce de sorte que le plan de connexion électrique présente un contact avec le composant semi-conducteur de la deuxième structure de circuit intégré, dans lequel les étapes (c) à (g) sont réalisées de sorte que par l'intermédiaire du plan de connexion électrique (230) soit établie une connexion électrique entre la zone de contact verticale et le composant semi-conducteur de la deuxième structure de circuit intégré en ce que le procédé présente, entre l'étape (f) et l'étape (g), un approfondissement de l'évidement (240) jusqu'au plan de connexion électrique (230).

4. Procédé selon la revendication 2, dans lequel est réalisée, entre les étapes (d) et (f2), une ouverture de la couche semi-conductrice (212) de sorte que la couche épitaxiale ouverte (212) expose l'évidement.

5. Procédé selon la revendication 4, dans lequel est réalisée, après l'étape (f2), par ailleurs la formation d'une partie d'une structure de connexion (230b) dans la direction verticale au-dessus de l'évidement, de sorte que la partie de la structure de connexion (230b) établisse une connexion électrique avec la zone de contact verticale (240) remplie de matériau conducteur.

6. Procédé selon l'une des revendications 1 à 5, dans lequel les étapes (c) à (g) sont réalisées de sorte que soit réalisée une connexion électrique avec le composant semi-conducteur de la deuxième structure de circuit intégré.

7. Procédé selon la revendication 6, dans lequel les étapes (c) à (g) sont réalisées de sorte que la connexion électrique avec le composant semi-conducteur de la deuxième structure de circuit intégré comporte une mise en contact de la zone de contact verticale (240) avec un matériau semi-conducteur fortement dopé du composant semi-conducteur.

8. Procédé selon l'une des revendications précédentes, dans lequel l'évidement présente une paroi latérale et le procédé comporte par ailleurs le fait de former une couche isolante diélectrique sur la paroi latérale de l'évidement.

9. Procédé selon l'une des revendications précédentes, dans lequel plusieurs zones de contact verticales (240) sont formées sous forme d'un aménagement de tranchées régulier.

10. Procédé selon l'une des revendications 1 à 9, dans lequel l'étape consistant à former la zone de contact verticale (240), l'étape consistant à former le composant semi-conducteur et l'étape consistant à aligner l'un sur l'autre sont réalisées de sorte que la connexion électrique soit établie de sorte que la zone de contact verticale (240) s'étende de la surface de contact (150) jusqu'à une zone fortement dopée de la couche semi-conductrice qui, quant à elle, est adjacente à la face principale (215) du substrat.

11. Aménagement de circuit électronique intégré d'un système électronique tridimensionnel, avec:
un premier substrat (110) avec une première structure de circuit intégré et une face principale (117) sur laquelle est disposée une première structure de couche diélectrique (120) avec une première surface de contact (150), dans la première structure de couche diélectrique (120) étant formée une structure de connexion (130) qui est connectée électriquement par l'intermédiaire de premiers trous d'interconnexion (140) avec la première surface de contact (150) et des zones dopées dans le premier substrat (110);
un deuxième substrat aminci (210') avec une deuxième structure de circuit intégré et une face principale (215) sur laquelle sont formées une couche semi-conductrice (212) cultivée de manière épitaxiale au moyen d'un processus de croissance tout en préservant la structure de grille du deuxième substrat, une deuxième structure de couche diélectrique (220) et une deuxième surface de contact (250), la couche semi-conductrice épitaxiale (212) étant disposée entre la deuxième structure de couche diélectrique (220) et le substrat aminci (210'), la couche diélectrique (220) présentant une deuxième structure de connexion (230b) qui est connectée électriquement par l'intermédiaire de deuxièmes trous d'interconnexion avec des zones dopées dans le deuxième substrat (210) ou dans la couche semi-conductrice épitaxiale (212), et la deuxième surface de contact (250) étant disposée sur une face de la deuxième structure de couche diélectrique (220) opposée à la face principale (215) du deuxième substrat (210); et
une zone verticale de contact pour établir un contact électrique entre la deuxième structure de connexion (230b) et la deuxième surface de contact (250),
dans lequel la zone de contact verticale (240) présente un aménagement de tranchées régulier, dans lequel une distance (d1) entre tranchées adjacentes de l'aménagement de tranchées régulier est inférieure à une extension latérale (d2) d'un troisième trou d'interconnexion ou d'une cavité (230b) pourvue de métal par l'intermédiaire de laquelle la deuxième structure de connexion (230) est connectée à la zone de contact verticale,
et dans lequel la première surface de contact (150) et la deuxième surface de contact (250) sont connectées électriquement et mécaniquement entre elles.

12. Aménagement de circuit électronique intégré selon la revendication 11, dans lequel la zone de contact verticale (240) s'étend à travers le deuxième substrat aminci (210'), la couche semi-conductrice (212) et une première partie de la structure de couche diélectrique (220a).

13. Aménagement de circuit électronique intégré selon la revendication 11 ou la revendication 12, dans lequel la zone de contact verticale (240) et la première zone de contact (140) sont réalisées de sorte qu'un flux de courant de la première structure de connexion (230b) et la deuxième structure de connexion (130) a lieu uniquement dans une direction et les structures de connexion (230, 130) sont des plans de métallisation d'une structure MOS.

14. Aménagement de circuit électronique intégré selon l'une des revendications 11 à 13, dans lequel l'aménagement des tranchées régulier de la zone de contact verticale (240) présente une grille symétrique en translation.

15. Aménagement de circuit électronique intégré selon l'une des revendications 11 à 14, dans lequel la zone de contact verticale (240) présente du tungstène et/ou la deuxième surface de contact (250) présente de l'étain ou du cuivre.
